# EUROPEAN PATENT APPLICATION

(11) **EP 4 163 945 A1**
(43) Date of publication of application: **12.04.2023**
(21) Application number: 22200520.9
(22) Date of filing: 10.10.2022
(51) Int. Cl.: H01H 85/046, H01H 85/08, H01H 85/10, H01H 69/02

(54) **FLEXIBLE THIN SHEET-SHAPED ELECTRIC WIRE AND BUS-BAR MODULE**

(30) Priority: 11.10.2021 JP 2021166668
(71) Applicant: Yazaki Corporation, Minato-ku Tokyo 108-8333 (JP)
(72) Inventor: Mukasa, Hirotaka, Shizuoka, 421-0407 (JP); Tsuchiya, Kazuhiko, Shizuoka, 421-0407 (JP)
(74) Representative: Grünecker Patent- und Rechtsanwälte PartG mbB

(57) **Abstract**

A flexible thin sheet-shaped electric wire (40) includes: a body part (410) having electrical insulation; and a conductor part (420) that is arranged in the body part (410). Further, the conductor part (420) includes a conductor body (421), and a fuse part (422) that is formed in a part of the conductor body (421) and of which a cross-sectional area is smaller than a cross-sectional area of the conductor body (421). Still further, the body part (410) includes a conductor region (411) in which the conductor body (421) is arranged and a fuse region (412) in which the fuse part (422) is arranged. The fuse part (422) includes an enclosing part (4223) that is arranged to enclose the entire circumference of at least a part of the fuse region (412).

## Description

### TECHNICAL FIELD

The present invention relates to a flexible thin sheet-shaped electric wire and a bus-bar module.

### BACKGROUND

Japanese Unexamined Patent Application Publication No. 2007-317990 discloses a flexible printed circuit board having a fuse function. Specifically, a fuse part is formed by making a part of a conductor part formed on the flexible printed circuit board thin (by making the cross-sectional area small). When an overcurrent flows into the conductor part, the fuse part fuses and thereby prevents the overcurrent from flowing to the device to which the flexible printed circuit board is connected.

### SUMMARY

However, in the above conventional technology, the flexible printed circuit board has the fuse function by simply making a part of the conductor part thin (making the cross-sectional area small). Therefore, the heat generated in the fuse part diffuses to the surroundings when the overcurrent flows. This causes a problem that a long time is required for the fuse to be fused and the fuse part may not be fused quickly. Also, such problems are especially notable when an overcurrent with a relatively low current value flows.

An object of the present invention is to provide a flexible thin sheet-shaped electric wire and a bus-bar module that can fuse a fuse part more quickly even if an overcurrent with a relatively low current value flows.

A flexible thin sheet-shaped electric wire according to an invention includes: a body part having electrical insulation; and a conductor part that is arranged in the body part, in which the conductor part includes a conductor body, and a fuse part that is formed in a part of the conductor body and of which a cross-sectional area is smaller than a cross-sectional area of the conductor body, the body part includes a conductor region in which the conductor body is arranged and a fuse region in which the fuse part is arranged, and the fuse part includes an enclosing part that is arranged to enclose an entire circumference of at least a part of the fuse region.

A flexible thin sheet-shaped electric wire according to another invention includes: a body part having electrical insulation; and a conductor part that is arranged in the body part, in which the conductor part includes a conductor body and a fuse part that is formed in a part of the conductor body and of which a cross-sectional area is smaller than a cross-sectional area of the conductor body, the body part includes a conductor region in which the conductor body is arranged and a fuse region in which the fuse part is arranged, and the fuse part includes a concentrated part that is arranged in a part of the fuse region such that a density per unit area of the part of the fuse region is higher than a density per unit area of another region.

A bus-bar module according to an invention includes: a case that is assembled on a battery assembly having a plurality of single batteries; a bus bar that is supported by the case and is electrically connected to the single batteries of the battery assembly; and a flexible thin sheet-shaped electric wire that is placed in the case, in which the flexible thin sheet-shaped electric wire includes a body part having electrical insulation, and a conductor part that is arranged in the body part, the conductor part includes a conductor body and a fuse part that is formed in a part of the conductor body and of which a cross-sectional area is smaller than a cross-sectional area of the conductor body, the body part includes a conductor region in which the conductor body is arranged and a fuse region in which the fuse part is arranged, and the fuse part includes an enclosing part that is arranged to enclose an entire circumference of at least a part of the fuse region.

A bus-bar module according to another invention includes: a case that is assembled on a battery assembly having a plurality of single batteries; a bus bar that is supported by the case and is electrically connected to the single batteries of the battery assembly; and a flexible thin sheet-shaped electric wire that is placed in the case, in which the flexible thin sheet-shaped electric wire includes a body part having electrical insulation, and a conductor part that is arranged in the body part, the conductor part includes a conductor body and a fuse part that is formed in a part of the conductor body and of which a cross-sectional area is smaller than a cross-sectional area of the conductor body, the body part includes a conductor region in which the conductor body is arranged and a fuse region in which the fuse part is arranged, and the fuse part includes a concentrated part that is arranged in a part of the fuse region such that a density per unit area of the part of the fuse region is higher than a density per unit area of another region.

### BRIEF DESCRIPTION OF THE DRAWINGS

Fig. 1 is a plan view showing an example of a bus-bar module according to an embodiment.
Fig. 2 is a plan view showing an example of a fuse part according to an embodiment.
Fig. 3 is a plan view showing a first modified example of a fuse part according to an embodiment.
Fig. 4 is a plan view showing a second modified example of a fuse part according to an embodiment.
Fig. 5 is a plan view showing a third modified example of a fuse part according to an embodiment.
Fig. 6 is a plan view showing a fourth modified example of a fuse part according to an embodiment.
Fig. 7 is a plan view showing a fifth modified example of a fuse part according to an embodiment.
Fig. 8 is a plan view showing a sixth modified example of a fuse part according to an embodiment.
Fig. 9 is a plan view showing a seventh modified example of a fuse part according to an embodiment.

### DETAILED DESCRIPTION

Various embodiments will be described hereinafter with reference to the accompanying drawings.

Hereafter, a flexible thin sheet-shaped electric wire and a bus-bar module according to the present embodiment will be described in detail with reference to the drawings. In the following, a flexible printed circuit board (FPC) is exemplified as the flexible thin sheet-shaped electric wire. The bus-bar module is assembled on a battery module mounted in an electrified vehicle (for example, an HV, PHV, EV, FCV, or the like). The dimensional ratios in the drawings are exaggerated for illustrative purposes and may differ from the actual ratios.

In the following, the vertical direction of a bus-bar module is defined and explained with a case positioned on the lower side and an FPC positioned on the upper side.

### (One embodiment)

A bus-bar module 10 according to the present embodiment is assembled on the top of a battery module (a battery assembly), which is not shown in the diagram, and forms a power supply device. In this case, the power supply device is mounted and used in various electrified vehicles such as an electric vehicle that travels by using an electric motor or a hybrid vehicle that travels by using both an engine and an electric motor. The power supply device supplies power to the electric motor.

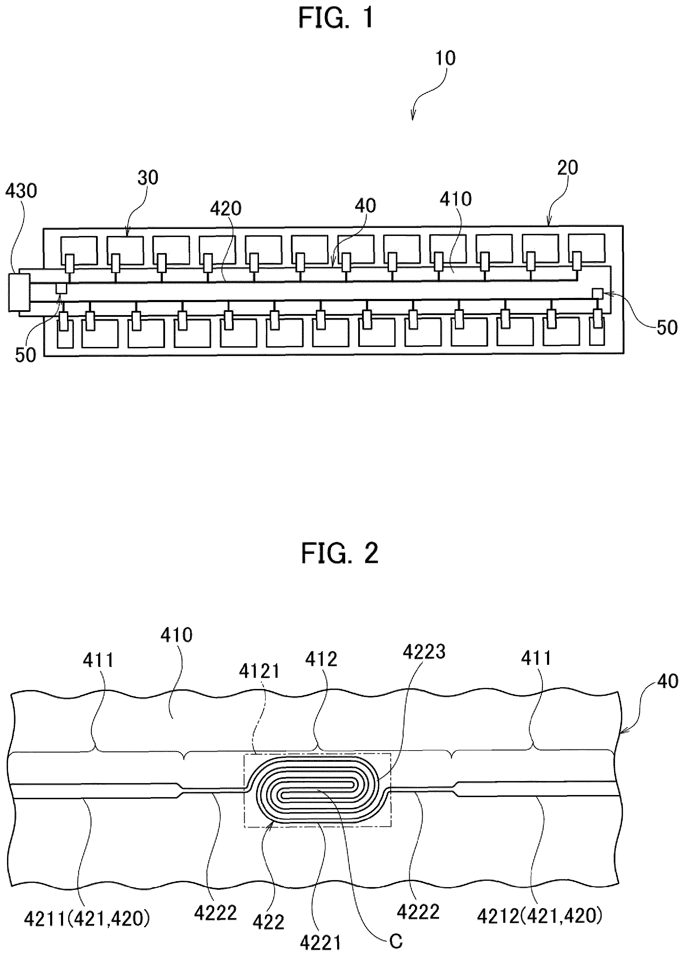

This bus-bar module 10 has a case 20 which is assembled on the battery module and bus bars 30 which are supported by the case 20 as shown in Fig. 1.

The case 20 can be formed by using a material having electrical insulation such as a synthetic resin, for example, and the shape of the case 20 can be various shapes such as a box that opens at the top.

The bus bars 30 are electrically connected to a single battery of the battery module while being supported by the case 20. The bus-bar module 10 according to the present embodiment has a plurality of bus bars 30. The bus bars 30 are formed in a plate shape using a conductive material such as metal.

Furthermore, in the present embodiment, the bus-bar module 10 has a sensor part 50 such as a voltage sensor for detecting the voltage of a single battery and a temperature sensor for detecting the temperature of a single battery. Pieces of data detected by means of the sensor part 50 such as the voltage sensor and the temperature sensor (voltage data, temperature data, and the like) are configured to be output to an FPC (a flexible printed circuit board: a flexible thin sheet-shaped electric wire) 40. In this way, in the present embodiment, the bus-bar module 10 has the FPC (the flexible printed circuit board: the flexible thin sheet-shaped electric wire) 40 as an electric wire for receiving the state (voltage and temperature) of the battery module. By using the FPC (the flexible printed circuit board: the flexible thin sheet-shaped electric wire) 40, the bus-bar module 10 which is assembled on the battery module can be reduced in height while the degree of freedom in the arrangement of electronic components is enhanced. In the present embodiment, the FPC 40 is placed from above the case 20, and the FPC 40 and the bus bars 30 supported by the case 20 are electrically connected to form the bus-bar module 10.

The FPC 40 has a body part 410 as shown in Fig. 1 and Fig. 2. The body part 410 is formed by using a material having electrical insulation and is flexible. Further, the FPC 40 has a conductor pattern (a conductor part) 420 for transmitting data and the like detected by means of the sensor part 50. In the present embodiment, the conductor pattern 420 is formed of a conductive material. A circuit part is formed in the body part 410 by arranging the conductor pattern 420 on the body part 410. The conductor pattern 420 may be arranged on the body part 410 in an exposed state or may be arranged on the body part 410 while being covered by using a cover or the like.

Further, the FPC 40 has a connector 430. Also, the pieces of data (voltage data, temperature data, and the like) detected by means of the sensor part 50 are output from the conductor pattern 420 of the FPC 40 to an electrical control unit (ECU), which is not shown in the diagram, through the connector 430.

In the present embodiment, the FPC 40 has a fuse function. Specifically, by providing a part where the conductor pattern 420 becomes thinner (the cross-sectional area of the conductor pattern 420 becomes smaller) in the middle of the conductor pattern 420, the thinner part of the conductor pattern 420 functions as a pattern fuse. That is, the conductor pattern 420 has a conductor body 421 and a pattern fuse (a fuse part) 422 which is formed in a part of the conductor body 421 and has a cross-sectional area that is smaller than that of the conductor body 421.

Due to the above, when an overcurrent flows in the conductor pattern 420, the pattern fuse 422 fuses and thereby prevents the overcurrent from flowing to connected devices (the ECU and the like) of the FPC 40.

In the present embodiment, the conductor body 421 is arranged in a part set as a conductor region 411 on the upper surface of the body part 410. A pattern fuse 422 is arranged in a part set as a fuse region 412 on the upper surface of the body part 410. That is, the body part 410 has the conductor region 411 in which the conductor body 421 is arranged and the fuse region 412 in which the pattern fuse 422 is arranged.

As described above, in the present embodiment, the pattern fuse 422 is provided in the middle of the conductor body 421. Therefore, the conductor region 411 and the fuse region 412 are set on the upper surface of the body part 410 such that the fuse region 412 is present in the middle of the conductor region 411.

A first conductor body 4211 is arranged in a conductor region 411 located on one side (left side in Fig. 2) of the fuse region 412. A second conductor body 4212 is arranged in a conductor region 411 located on the other side (right side in Fig. 2) of the fuse region 412. In this way, in the present embodiment, the conductor body 421 has the first conductor body 4211 connected to one end of the pattern fuse 422 and the second conductor body 4212 connected to the other end of the pattern fuse 422.

Furthermore, in the present embodiment, the first conductor body 4211 and the second conductor body 4212 are individually arranged in the conductor regions 411 located on both sides of the fuse region 412 while the first conductor body 4211 and the second conductor body 4212 are aligned (to be part of the same straight line).

In the fuse region 412, one pattern fuse 422 is arranged to connect the first conductor body 4211 and the second conductor body 4212. Specifically, an end of the first conductor body 4211 closer to the second conductor body 4212 (the right end in Fig. 2) and an end of the second conductor body 4212 closer to the first conductor body 4211 (the left end in Fig. 2) are connected by means of one pattern fuse 422.

In this way, in the present embodiment, the pattern fuse 422 is formed by arranging one strip-like pattern connecting the first conductor body 4211 and the second conductor body 4212 in the fuse region 412 on the upper surface of the body part 410.

In the present embodiment, one pattern fuse (one fuse part) 422 is formed in one FPC 40.

In the present embodiment, even if an overcurrent with a relatively low current value flows into the conductor pattern 420, the pattern fuse 422 can be fused more quickly.

Specifically, the pattern fuse 422 is arranged in the fuse region 412 such that the pattern fuse 422 is concentrated in the center (part) of the fuse region 412.

That is, the pattern fuse 422 is arranged in the fuse region 412 such that the density of the pattern fuse per unit area in some regions of the fuse region 412 is higher than the density of the pattern fuse per unit area in other regions of the fuse region 412.

In the present embodiment, the pattern fuse 422 has a pair of straight parts 4222 and 4222 which extend in the extension direction of the conductor pattern 420 and are connected to the first conductor body 4211 and the second conductor body 4212. In addition, the pattern fuse 422 has a concentrated part 4221 of which both ends are connected to the pair of straight parts 4222 and 4222. The pattern fuse 422 is curved in the concentrated part 4221 with the curves arranged close together. This makes the density of the pattern fuse per unit area in the region where the concentrated part 4221 is arranged higher than the density of the pattern fuse per unit area in the regions where the straight parts 4222 are arranged.

In this way, in the present embodiment, the pattern fuse (the fuse part) 422 has the concentrated part 4221 which is arranged in a part of the fuse region 412 such that the density per unit area is higher than that in other regions.

Provision of the concentrated part 4221 in the pattern fuse (the fuse part) 422 suppresses heat escape from the concentrated part 4221 and suppresses a decrease in the temperature of the concentrated part 4221.

Therefore, in the present embodiment, a region of the fuse region 412 (a part of the fuse region 412) where the concentrated part 4221 is arranged is a thermal diffusion suppression region 4121 that can suppress the diffusion of heat generated in the pattern fuse (the fuse part) 422.

Furthermore, in the present embodiment, the shape of the concentrated part 4221 arranged in the thermal diffusion suppression region 4121 is a spiral shape. Specifically, the shape of the concentrated part 4221 is a shape that swirls clockwise inward from one straight part (the straight part connected to the first conductor body 4211) 4222 in the state shown in Fig. 2. In addition, the shape of the concentrated part 4221 is the shape shown in Fig. 2, which is folded back at the center, swirls counterclockwise outward, and connects to the other straight part (the straight part connected to the second conductor body 4212) 4222 in the state shown in Fig. 2.

In this way, if the shape of the concentrated part 4221 is made to be a spiral shape, at the center of the spiral, a part is formed in which there are a plurality of layers of pattern fuses 422 in any direction in 360 degrees. When a straight line is drawn radially from the center C of the fuse region 412, for example, no matter in which direction the straight line is drawn in 360 degrees, the line will intersect a plurality of pattern fuses 422. Therefore, heat diffusing radially from the center C of the fuse region 412 along the upper surface of the body part 410 may not move outside without passing through the plurality of pattern fuses 422.

In this way, in the present embodiment, the concentrated part 4221 of the pattern fuse 422 also serves as an enclosing part 4223 which is arranged such that the entire circumference of at least a part of the fuse region 412 is enclosed. That is, in the present embodiment, the pattern fuse 422 also has the enclosing part 4223 which is arranged such that the entire circumference of at least a part of the fuse region 412 is enclosed.

This prevents heat which is generated inside the enclosing part 4223 and is spread radially (in a planar form) from escaping outside the enclosing part 4223. That is, the heat generated by means of the pattern fuse 422 is prevented from diffusing in a planar form by using the enclosing part 4223.

The heat generated in the pattern fuse 422 can be kept within the region enclosed by the enclosing part 4223 in the fuse region 412. This prevents the temperature of the pattern fuse 422 from decreasing.

Due to the above, even if an overcurrent with a relatively low current value flows into the conductor pattern 420, the pattern fuse 422 can be fused more quickly.

In this way, in the present embodiment, the pattern fuse 422 has a shape (a spiral shape) in which heat tends to be collected. If an overcurrent flows into the conductor pattern 420, heat is actively collected (stored) at the center of the spiral. Due to the pattern fuse 422 having a spiral shape, it is difficult for the heat which is generated in the pattern fuse 422 and is present at the center of the spiral to escape to the conductor pattern 420 side. Due to the above, even if an overcurrent with a relatively low current value flows into the conductor pattern 420, the fusing time of the pattern fuse 422 can be reduced.

In the spiral shape, the more it swirls, the more heat is collected at the center. Therefore, increasing the number of swirls makes it possible to further reduce the fusing time of the pattern fuse 422. Moreover, by appropriately setting the number of swirls of the spiral shape, the fusing time of the pattern fuse 422 can be adjusted.

Note that the shape of the pattern fuse (the fuse part) 422 is not limited to the shape described in the above embodiment, and various shapes can be used. A modified example of the shape of the pattern fuse (the fuse part) 422 will be described below.

### (First modified example)

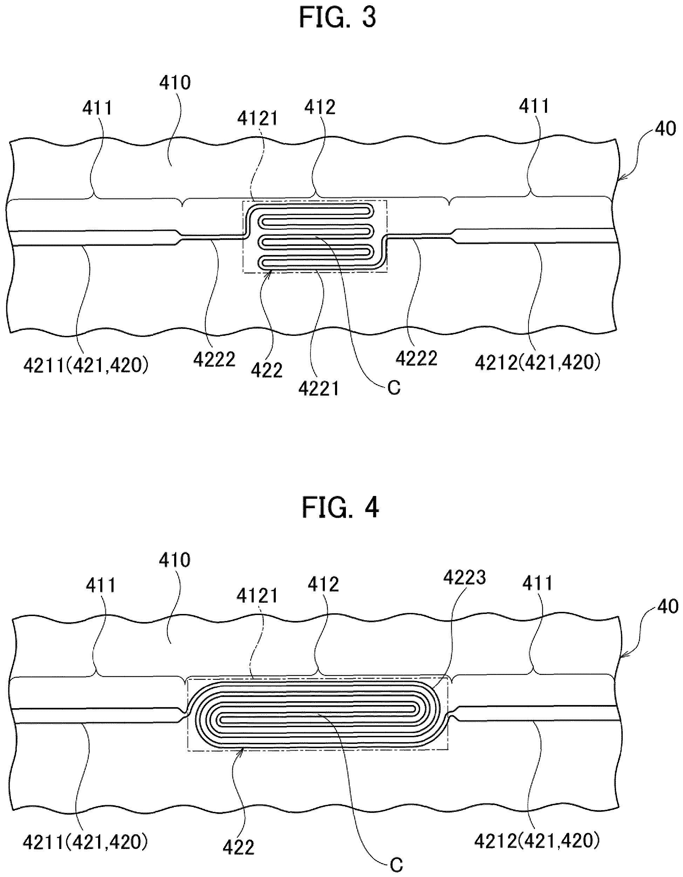

The shape of the pattern fuse (the fuse part) 422 can be the shape of the pattern fuse 422 shown in Fig. 3, for example.

The pattern fuse 422 shown in Fig. 3 can also be fused more quickly even if an overcurrent with a relatively low current value flows into the conductor pattern 420.

Specifically, the pattern fuse (the fuse part) 422 shown in Fig. 3 also has a concentrated part 4221 which is arranged in a part of the fuse region 412 such that the density per unit area is higher than that in other regions.

Therefore, in Fig. 3 also, the region in which the concentrated part 4221 is arranged in the fuse region 412 (a part of the fuse region 412) is a thermal diffusion suppression region 4121 that can suppress the diffusion of heat generated by means of a pattern fuse (a fuse part) 422.

In the pattern fuse (the fuse part) 422 shown in Fig. 3, the shape of the concentrated part 4221 arranged in the thermal diffusion suppression region 4121 is the shape of a transverse wave (a wave of which the amplitude is in the extension direction of the conductor pattern 420).

Specifically, in the state shown in Fig. 3, the concentrated part 4221 has a shape that extends upward from one straight part (the straight part connected to the first conductor body 4211) 4222 and is folded back to undulate left and right from the top to the bottom. In addition, in the state shown in Fig. 3, the concentrated part 4221 has a shape that extends from the lower right end toward the upper side (center) and is connected to the other straight part (the straight part connected to the second conductor body 4212) 4222.

This also makes it possible to keep the heat generated by means of the pattern fuse 422 in the concentrated part 4221 (the center C of the fuse region 412). Therefore, a temperature decrease of the pattern fuse 422 in the concentrated part 4221 can be suppressed.

Therefore, even if an overcurrent with a relatively low current value flows into the conductor pattern 420, the pattern fuse 422 can be fused more quickly.

In this way, the pattern fuse 422 shown in Fig. 3 has a part (the concentrated part 4221) in which heat tends to be collected. When an overcurrent flows into the conductor pattern 420, the concentrated part 4221 is made to collect (store) heat actively. Due to the pattern fuse 422 having the concentrated part 4221, it is difficult for heat which is generated in the pattern fuse 422 and is present at the concentrated part 4221 to escape to the conductor pattern 420 side. In this way, even if an overcurrent with a relatively low current value flows into the conductor pattern 420, the fusing time of the pattern fuse 422 can be reduced.

### (Second modified example)

The shape of the pattern fuse (the fuse part) 422 can also be the shape of the pattern fuse 422 shown in Fig. 4.

The pattern fuse 422 shown in Fig. 4 can also be fused more quickly even if an overcurrent with a relatively low current value flows into the conductor pattern 420.

Specifically, the pattern fuse (the fuse part) 422 shown in Fig. 4 is arranged in almost the entire fuse region 412. The pattern fuse (the fuse part) 422 arranged in almost the entire fuse region 412 has an enclosing part 4223 which is arranged to enclose the entire circumference.

This prevents heat which is generated inside the enclosing part 4223 and is spread radially (in a planar form) from escaping outside the enclosing part 4223. That is, the heat generated by means of the pattern fuse 422 is prevented from diffusing in a planar form by means of the enclosing part 4223.

Therefore, in Fig. 4, the region inside the pattern fuse (the fuse part) 422 in the fuse region 412 is a thermal diffusion suppression region 4121 that can suppress the diffusion of heat generated by means of the pattern fuse (the fuse part) 422.

In addition, in Fig. 4, the pattern fuse 422 arranged in the thermal diffusion suppression region 4121 has a spiral shape. Specifically, the shape of the pattern fuse 422 is a shape that swirls clockwise inward from the first conductor body 4211 in the state shown in Fig. 4. In addition, the shape of the concentrated part 4221 is the shape shown in Fig. 4, which is folded back at the center, swirls counterclockwise toward the outside, and is connected to the second conductor body 4212.

In this way, if the shape of the pattern fuse 422 is made to be a spiral shape, at the center of the spiral, a part is formed in which there are a plurality of layers of pattern fuses 422 in any direction in 360 degrees. When a straight line is drawn radially from the center C of the fuse region 412, no matter in which direction the straight line is drawn in 360 degrees, the line will intersect the plurality of pattern fuses 422, for example. That is, heat radially diffusing from the center C of the fuse region 412 along the upper surface of the body part 410 may not move outside without passing through the plurality of pattern fuses 422.

In this way, in Fig. 4 also, the pattern fuse 422 has a shape (a spiral shape) in which heat tends to be collected. When an overcurrent flows into the conductor pattern 420, heat is actively collected (stored) at the center of the spiral. Due to the pattern fuse 422 having a spiral shape, it is difficult for heat which is generated in the pattern fuse 422 and is present at the center of the spiral to escape to the conductor pattern 420 side. Due to the above, even if an overcurrent with a relatively low current value flows into the conductor pattern 420, the fusing time of the pattern fuse 422 can be reduced.

### (Third modified example)

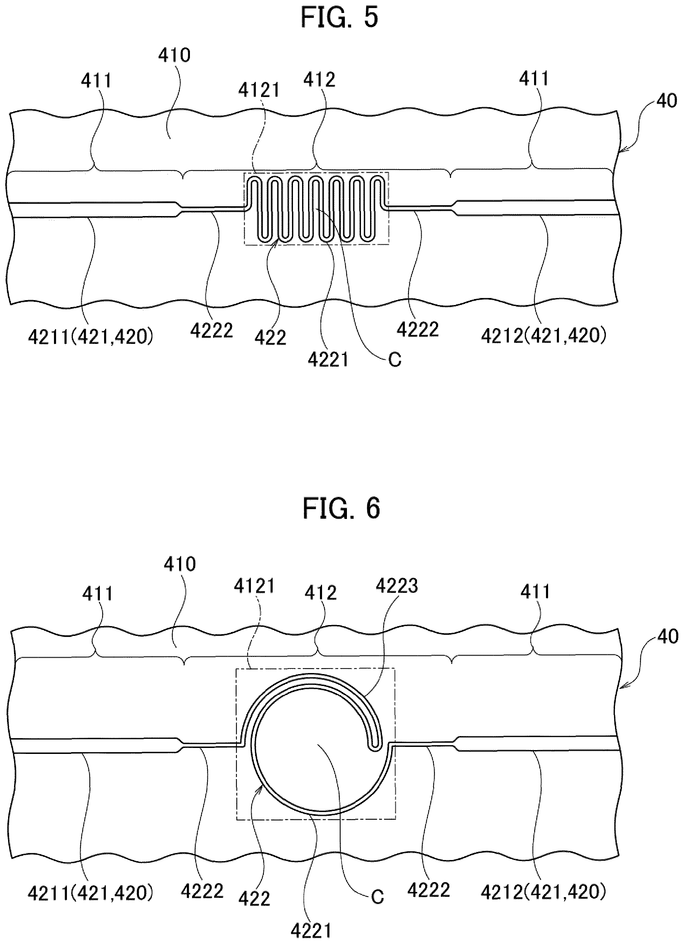

The shape of the pattern fuse (the fuse part) 422 can also be the shape of the pattern fuse 422 shown in Fig. 5.

The pattern fuse 422 shown in Fig. 5 can also be fused more quickly even if an overcurrent with a relatively low current value flows into the conductor pattern 420.

Specifically, the pattern fuse (the fuse part) 422 shown in Fig. 5 also has a concentrated part 4221 which is arranged in a part of the fuse region 412 such that the density per unit area is higher than that in other regions.

Therefore, in Fig. 5 also, a region in which the concentrated part 4221 is arranged in the fuse region 412 (a part of the fuse region 412) is a thermal diffusion suppression region 4121 that can suppress the diffusion of heat generated in the pattern fuse (the fuse part) 422.

In the pattern fuse (the fuse part) 422 shown in Fig. 5, the shape of the concentrated part 4221 arranged in the thermal diffusion suppression region 4121 is the shape of a longitudinal wave (a wave of which the amplitude is in the direction intersecting the extension direction of the conductor pattern 420).

Specifically, in the state shown in Fig. 5, the shape of the concentrated part 4221 is a shape which is folded back to undulate up and down from the straight part 4222 connected to the first conductor body 4211 to the straight part 4222 connected to the second conductor body 4212.

This also makes it possible to keep the heat generated by means of the pattern fuse 422 in the concentrated part 4221 (the center C of the fuse region 412). Accordingly, a temperature decrease of the pattern fuse 422 in the concentrated part 4221 can be suppressed.

Therefore, even if an overcurrent with a relatively low current value flows into the conductor pattern 420, the pattern fuse 422 can be fused more quickly.

In this way, the pattern fuse 422 shown in Fig. 5 also has a part (the concentrated part 4221) in which heat tends to be collected. When an overcurrent flows into the conductor pattern 420, heat is actively collected (stored) in the concentrated part 4221. Due to the pattern fuse 422 having the concentrated part 4221, it is difficult for heat which is generated in the pattern fuse 422 and is present at the concentrated part 4221 to escape to the conductor pattern 420 side. Due to the above, even if an overcurrent with a relatively low current value flows into the conductor pattern 420, the fusing time of the pattern fuse 422 can be reduced.

### (Fourth modified example)

The shape of the pattern fuse (the fuse part) 422 can also be the shape of the pattern fuse 422 shown in Fig. 6.

The pattern fuse 422 shown in Fig. 6 can also be fused more quickly even if an overcurrent with a relatively low current value flows into the conductor pattern 420.

Specifically, the pattern fuse (the fuse part) 422 shown in Fig. 6 also has a concentrated part 4221 which is arranged in a part of the fuse region 412 such that the density per unit area is higher than that in other regions.

Therefore, in Fig. 6 also, a region in which the concentrated part 4221 is arranged in the fuse region 412 (a part of the fuse region 412) is a thermal diffusion suppression region 4121 that can suppress the diffusion of heat generated by means of the pattern fuse (the fuse part) 422.

In the pattern fuse (the fuse part) 422 shown in Fig. 6, the shape of the concentrated part 4221 arranged in the thermal diffusion suppression region 4121 is made to have an enclosing part 4223 which is arranged such that the entire circumference of at least a part of the fuse region 412 is enclosed.

Specifically, in the state shown in Fig. 6, the shape of the concentrated part 4221 is a shape which draws a semicircle protruding upward from one straight part (the straight part connected to the first conductor body 4211) 4222, is folded inward at the right end, and draws a semicircle protruding upward. In addition, the shape of the concentrated part 4221 is a shape which draws a semicircle protruding downward from the left end of the inner (lower) semicircle and is connected to the other straight part (the straight part connected to the second conductor body 4212) 4222. In the state shown in Fig. 6, the folded part for connecting the two semicircles protruding upward is positioned lower than the other straight part (the straight part connected to the second conductor body 4212) 4222.

Due to the above, inside the enclosing part 4223, a part is formed in which the pattern fuse 422 is present in any direction in 360 degrees. When a straight line is drawn radially from the center C of the fuse region 412, for example, no matter in which direction the straight line is drawn in 360 degrees, the line will intersect the pattern fuse 422. That is, heat radially diffusing from the center C of the fuse region 412 along the upper surface of the body part 410 may not move outside without passing through at least one pattern fuse 422

In this way, in Fig. 6 also, the concentrated part 4221 of the pattern fuse 422 also serves as the enclosing part 4223 which is arranged to enclose the entire circumference of at least a part of the fuse region 412. That is, the pattern fuse 422 also has the enclosing part 4223 which is arranged to enclose the entire circumference of at least a part of the fuse region 412.

In this way, in Fig. 6 also, the pattern fuse 422 has a shape (the enclosing part 4223) in which heat tends to be collected. When an overcurrent flows into the conductor pattern 420, heat is actively collected (stored) inside the enclosing part 4223. Due to the pattern fuse 422 having the enclosing part 4223, it is difficult for the heat which is generated by means of the pattern fuse 422 and is present inside the enclosing part 4223 to escape to the conductor pattern 420 side. Due to the above, even if an overcurrent with a relatively low current value flows into the conductor pattern 420, the fusing time of the pattern fuse 422 can be reduced.

### (Fifth modified example)

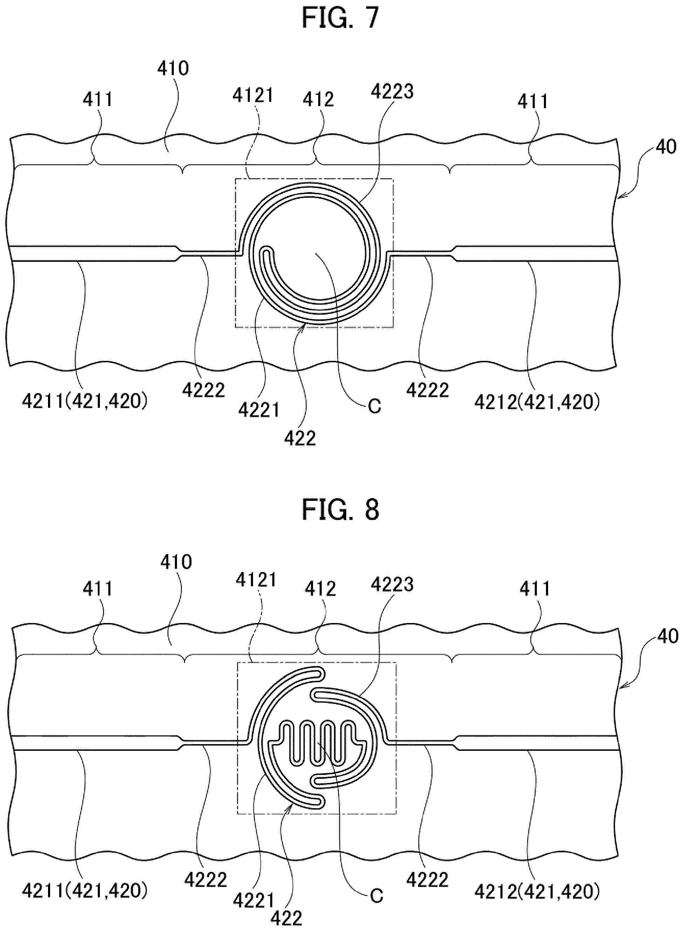

The shape of the pattern fuse (the fuse part) 422 can also be the shape of the pattern fuse 422 shown in Fig. 7.

The pattern fuse 422 shown in Fig. 7 can also be fused more quickly even if an overcurrent with a relatively low current value flows into the conductor pattern 420.

Specifically, the pattern fuse (the fuse part) 422 shown in Fig. 7 also has a concentrated part 4221 which is arranged in a part of the fuse region 412 such that the density per unit area is higher than that in other regions.

Therefore, in Fig. 7 also, the region in which the concentrated part 4221 is arranged in the fuse region 412 (a part of the fuse region 412) is a thermal diffusion suppression region 4121 that can suppress the diffusion of heat generated in the pattern fuse (the fuse part) 422.

In the pattern fuse (the fuse part) 422 shown in Fig. 7, the shape of the concentrated part 4221 arranged in the thermal diffusion suppression region 4121 is made to have an enclosing part 4223 which is arranged to enclose the entire circumference of at least a part of the fuse region 412.

Specifically, in the state shown in Fig. 7, the shape of the concentrated part 4221 is a spiral shape obtained by swirling clockwise inward for one lap from one straight part (the straight part connected to the first conductor body 4211) 4222. In addition, the shape of the concentrated part 4221 is the shape shown in Fig. 7, which is folded inward at the left end of a spiral obtained by swirling clockwise inward for one lap and swirls counterclockwise outward for one and a half lap. The right end of the spiral obtained by swirling counterclockwise outward for one and a half lap is connected to the other straight part (the straight part connected to the second conductor body 4212) 4222.

Due to the above, inside the enclosing part 4223, a part is formed in which there are a plurality of layers of pattern fuses 422 in any direction in 360 degrees. When a straight line is drawn radially from the center C of the fuse region 412, for example, no matter in which direction the straight line is drawn in 360 degrees, the line will intersect the plurality of pattern fuses 422. That is, heat radially diffusing from the center C of the fuse region 412 along the upper surface of the body part 410 may not move outside without passing through the plurality of pattern fuses 422.

In this way, in Fig. 7 also, the concentrated part 4221 of the pattern fuse 422 also serves as the enclosing part 4223 which is arranged to enclose the entire circumference of at least a part of the fuse region 412. That is, the pattern fuse 422 also has the enclosing part 4223 which is arranged to enclose the entire circumference of at least a part of the fuse region 412.

In this way, in Fig. 7 also, the pattern fuse 422 has a shape (the enclosing part 4223) in which heat tends to be collected. When an overcurrent flows into the conductor pattern 420, heat is actively collected (stored) inside the enclosing part 4223. Due to the pattern fuse 422 having the enclosing part 4223, it is difficult for the heat which is generated by means of the pattern fuse 422 and is present inside the enclosing part 4223 to escape to the conductor pattern 420 side. Due to the above, even if an overcurrent with a relatively low current value flows into the conductor pattern 420, the fusing time of the pattern fuse 422 can be reduced.

### (Sixth modified example)

The shape of the pattern fuse (the fuse part) 422 can also be the shape of the pattern fuse 422 shown in Fig. 8.

The pattern fuse 422 shown in Fig. 8 can also be fused more quickly even if an overcurrent with a relatively low current value flows into the conductor pattern 420.

Specifically, the pattern fuse (a fuse part) 422 shown in Fig. 8 also has a concentrated part 4221 which is arranged in a part of a fuse region 412 such that the density per unit area is higher than that in other regions.

Therefore, in Fig. 8 also, the region in which the concentrated part 4221 is arranged in the fuse region 412 (a part of the fuse region 412) is a thermal diffusion suppression region 4121 that can suppress the diffusion of heat generated by means of the pattern fuse (the fuse part) 422.

In the pattern fuse (the fuse part) 422 shown in Fig. 8, the shape of the concentrated part 4221 arranged in the thermal diffusion suppression region 4121 is made to have the enclosing part 4223 which is arranged to enclose the entire circumference of at least a part of the fuse region 412. Furthermore, the concentrated part 4221 has a wave shape inside the enclosing part 4223.

Specifically, in the state shown in Fig. 8, the shape of the concentrated part 4221 is a shape that draws a quadrant protruding upward and to the left from one straight part (the straight part connected to the first conductor body 4211) 4222, is folded inward at the upper end, and draws a semicircle protruding to the left. In addition, in the state shown in Fig. 8, the shape of the concentrated part 4221 is a shape that is folded inward at the lower end of the semicircle protruding to the left, and draws a quadrant protruding downward and to the left.

Similarly, in the state shown in Fig. 8, the shape of the concentrated part 4221 is a shape that draws a quadrant protruding upward and to the right from the other straight part (the straight part connected to the second conductor body 4212) 4222, is folded inward at the upper end, and draws a semicircle protruding to the right. In addition, in the state shown in Fig. 8, the shape of the concentrated part 4221 is a shape that is folded inward at the lower end of the semicircle protruding to the right and draws a quadrant protruding downward and to the right.

Furthermore, in the state shown in Fig. 8, the shape of the concentrated part 4221 is a longitudinal wave (a wave of which the amplitude is in the direction intersecting the extension direction of the conductor pattern 420) shape connected to the upper end of the quadrant protruding downward and to the left and the upper end of the quadrant protruding downward and to the right.

Then, in the state shown in Fig. 8, the two folded parts positioned at the upper side are made to overlap each other when viewed along the vertical direction. Similarly, in the state shown in Fig. 8, the two folded parts positioned at the lower side are made to overlap each other when viewed along the vertical direction.

Due to the above, inside the enclosing part 4223, a part is formed in which there are a plurality of layers of pattern fuses 422 in any direction in 360 degrees. When a straight line is drawn radially from the center C of the fuse region 412, for example, no matter in which direction the straight line is drawn in 360 degrees, the line will intersect the plurality of pattern fuses 422. That is, heat radially diffusing from the center C of the fuse region 412 along the upper surface of the body part 410 may not move outside without passing through the plurality of pattern fuses 422.

In this way, in Fig. 8, the concentrated part 4221 of the pattern fuse 422 has an enclosing part 4223 which is arranged to enclose the entire circumference of at least a part of the fuse region 412. That is, the pattern fuse 422 has the enclosing part 4223 which is arranged to enclose the entire circumference of at least a part of the fuse region 412. Furthermore, in Fig. 8, the pattern fuse 422 is also present inside the enclosing part 4223.

In this way, in Fig. 8 also, the pattern fuse 422 has a shape (the enclosing part 4223) in which heat tends to be collected. When an overcurrent flows into the conductor pattern 420, heat is actively collected (stored) inside the enclosing part 4223. Due to the pattern fuse 422 having the enclosing part 4223, it is difficult for the heat which is generated by means of the pattern fuse 422 and is present inside the enclosing part 4223 to escape to the conductor pattern 420 side. Due to the above, even if an overcurrent with a relatively low current value flows into the conductor pattern 420, the fusing time of the pattern fuse 422 can be reduced.

### (Seventh modified example)

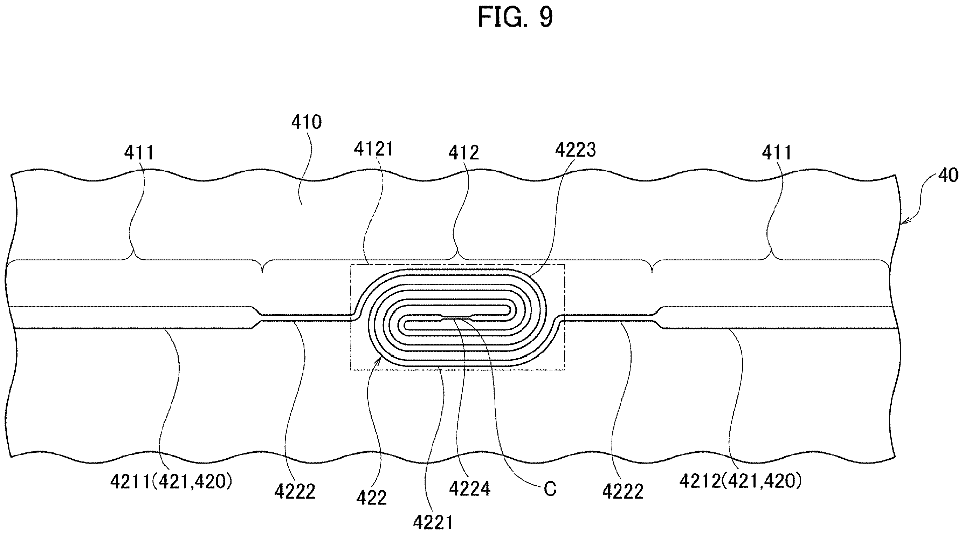

The shape of the pattern fuse (the fuse part) 422 can also be the shape of the pattern fuse 422 shown in Fig. 9.

The pattern fuse 422 shown in Fig. 9 can also be fused more quickly even if an overcurrent with a relatively low current value flows into a conductor pattern 420.

Specifically, the pattern fuse (the fuse part) 422 shown in Fig. 9 also has a concentrated part 4221 which is arranged in a part of the fuse region 412 such that the density per unit area is higher than that in other regions.

Therefore, in Fig. 9 also, the region in which the concentrated part 4221 is arranged in the fuse region 412 (a part of the fuse region 412) is a thermal diffusion suppression region 4121 that can suppress the diffusion of heat generated in the pattern fuse (the fuse part) 422.

In the pattern fuse (the fuse part) 422 shown in Fig. 9 also, the shape of the concentrated part 4221 arranged in the thermal diffusion suppression region 4121 is a spiral shape. Specifically, in the state shown in Fig. 9, the shape of the concentrated part 4221 is a shape that swirls clockwise inward from one straight part (the straight part connected to the first conductor body 4211) 4222. In addition, the shape of the concentrated part 4221 is a shape that is folded back at the center in the state shown in Fig. 9, swirls counterclockwise outward in the state shown in Fig. 9, and is connected to the other straight part (the straight part connected to the second conductor body 4212) 4222.

In this way, if the shape of the pattern fuse 422 is made to be a spiral shape, at the center of the spiral, a part is formed in which there are a plurality of layers of pattern fuses 422 in any direction in 360 degrees. When a straight line is drawn radially from the center C of the fuse region 412, no matter in which direction the straight line is drawn in 360 degrees, the line will intersect the plurality of pattern fuses 422, for example. That is, heat radially diffusing from the center C of the fuse region 412 along the upper surface of the body part 410 may not move outside without passing through the plurality of pattern fuses 422.

In this way, in Fig. 9 also, the pattern fuse 422 has a shape (a spiral shape) in which heat tends to be collected. When an overcurrent flows into the conductor pattern 420, heat is actively collected (stored) at the center of the spiral. Due to the pattern fuse 422 having a spiral shape, it is difficult for heat which is generated in the pattern fuse 422 and is present at the center of the spiral to escape to the conductor pattern 420 side. Due to the above, even if an overcurrent with a relatively low current value flows into the conductor pattern 420, the fusing time of the pattern fuse 422 can be reduced.

In Fig. 9, the thickness (width) of the pattern fuse (the fuse part) 422 is not mostly constant from one end to the other end.

Specifically, a part of the pattern fuse (the fuse part) 422 is made thinner than other parts. Fig. 9 shows an example where a part of the pattern fuse (the fuse part) 422 which is located at the center C of the fuse region 412 is thinner than other parts.

In this way, in Fig. 9, a part thinner than other parts is provided at the center of the spiral where heat is collected relatively easily. Due to the above, a fusing point 4224 is formed in the pattern fuse (the fuse part) 422. By using the fusing point 4224, fusing can be performed reliably when an overcurrent flows into the conductor pattern 420.

Fig. 9 shows an example where the fusing point 4224 is provided in the pattern fuse (the fuse part) 422 shown in Fig. 2. However, it is also possible to provide the fusing point 4224 in the pattern fuse (the fuse part) 422 shown in Figs. 3 to 8.

### [Acti on/Effect]

In the following, a description will be given regarding the characteristic configuration of the flexible thin sheet-shaped electric wire and bus-bar module shown in the above embodiment and modified examples thereof, and the effects obtained by them.

The bus-bar module 10 described in the above embodiment and modified examples thereof includes the case 20 that is assembled on a battery assembly having a plurality of single batteries, and the bus bar 30 that is supported by the case 20 and electrically connected to the single batteries of the battery assembly. Further, the bus-bar module 10 has the FPC (flexible thin sheet-shaped electric wire) 40 placed in the case 20.

The FPC (flexible thin sheet-shaped electric wire) 40 described in the above embodiment and modified examples thereof includes a body part 410 having electrical insulation and a conductor pattern (a conductor part) 420 arranged in the body part 410. The conductor pattern 420 also has a conductor body 421 and a pattern fuse (a fuse part) 422 which is formed in a part of the conductor body 421 and of which the cross-sectional area is smaller than that of the conductor body 421. The body part 410 also has a conductor region 411 in which the conductor body 421 is arranged and a fuse region 412 in which the pattern fuse 422 is arranged.

The pattern fuse 422 has an enclosing part 4223 which is arranged to enclose the entire circumference of at least a part of the fuse region 412.

If this kind of enclosing part 4223 is provided in the pattern fuse 422, inside the enclosing part 4223, a part can be formed in which the enclosing part 4223 is present in any direction in 360 degrees. As a result, heat which is generated inside the enclosing part 4223 and is spread radially (in a planar form) can be prevented from escaping outside the enclosing part 4223. That is, heat generated by means of the pattern fuse 422 can be prevented from diffusing in a planar form by using the enclosing part 4223.

Suppose that the heat generated in the pattern fuse 422 is allowed to be kept within the region enclosed by the enclosing part 4223 in the fuse region 412. In the above case, the temperature of the pattern fuse 422 is prevented from decreasing. Therefore, it becomes possible to fuse the pattern fuse (the fuse part) 422 more quickly.

Therefore, even if an overcurrent flowing into the conductor pattern (the conductor part) 420 is an overcurrent with a relatively low current value, the fusing time is shortened and the pattern fuse (the fuse part) 422 can be fused more quickly.

The enclosing part 4223 may also have a spiral shape.

If the enclosing part 4223 has the spiral shape in this way, inside the enclosing part 4223, a part can be formed in which there are a plurality of enclosing parts 4223 in any direction in 360 degrees. This allows the heat generated in the pattern fuse 422 to be kept more reliably within the region enclosed by the enclosing part 4223 in the fuse region 412. Accordingly, the pattern fuse 422 can be fused more quickly.

In addition, if the enclosing part 4223 has a spiral structure, the heat generated by means of the pattern fuse 422 is concentrated and stored at the center of the spiral. Therefore, even if an overcurrent with a relatively low current value flows into the conductor pattern 420, the pattern fuse 422 can be fused more reliably and in a shorter time.

In addition, the pattern fuse 422 may have a concentrated part 4221 which is arranged in a part of the fuse region 412 such that the density per unit area is higher than that in other regions.

Suppose that this kind of concentrated part 4221 is provided in the pattern fuse 422 and the pattern fuse 422 is concentrated in a part of the fuse region 412. In the above case, it becomes possible to suppress heat escape from the concentrated part 4221. As a result, it becomes possible to prevent the temperature of the concentrated part 4221 from decreasing, and the pattern fuse 422 can be fused more quickly.

Further, the concentrated part 4221 may have a spiral shape.

If the concentrated part 4221 has a spiral shape in this way, heat escape from the concentrated part 4221 can be more reliably suppressed while heat is concentrated in the concentrated part 4221. Therefore, the pattern fuse 422 can be fused more reliably and in a shorter time.

When the pattern fuse (the fuse part) 422 is provided in the conductor pattern (the conductor part) 420, it is preferable to set the pattern fuse 422 to have a certain length and a predetermined width and to set a resistance value of the pattern fuse 422 to be a predetermined value. Under these conditions, in order to effectively collect heat at a part to be fused of the pattern fuse 422, it is preferable that a heat-concentrated part of the pattern fuse 422 has a spiral structure while the pattern fuse 422 is concentrated in a part of the fuse region 412. That is, one of the most suitable shapes for effectively concentrating heat at a part of the fuse part 422 with the resistance value of the fuse part 422 being a predetermined value is a shape in which the concentrated part 4221 has a spiral structure while the fuse part 422 has a concentrated part 4221.

Therefore, if the concentrated part 4221 has a spiral shape while the concentrated part 4221 is provided in the fuse part 422, heat can be effectively concentrated in a part of the fuse part 422 while the resistance value of the fuse part 422 is kept constant.

In this way, if the FPC (the flexible thin sheet-shaped electric wire) 40 and the bus-bar module 10 described in the above embodiment and modified examples thereof are used, the fuse part 422 can be fused more quickly even if an overcurrent with a relatively low current value flows.

### [Others]

Although the present embodiment has been described above, the present embodiment is not limited thereto, and various modifications can be made within the scope of the gist of the present embodiment.

It is possible to adopt a configuration obtained by appropriately combining the configurations described in the above embodiment and modified examples thereof, for example.

Although the FPC (the flexible printed circuit board) is exemplified as a flexible thin sheet-shaped electric wire in the above embodiment and modified examples thereof, it is also possible to use a flexible wiring material different from the FPC.

In addition, it is sufficient if the shape of the pattern fuse (the fuse part) 422 is a shape that allows heat to be collected in at least a part of the fuse region 412, and the pattern fuse can have various shapes.

Further, when the shape of the concentrated part 4221 is a wave shape, the wave shape may include not only a longitudinal wave shape or a transverse wave shape but also an oblique wave shape (a wave of which the amplitude is in a direction obliquely crossing the extension direction of the conductor pattern 420).

It is also possible to form a plurality of fuse parts 422 in one FPC 40.

In addition, the specifications (shape, size, layout, and the like) of the body part, the conductor part, and other details can be appropriately changed.

Although the present invention has been described above by reference to the embodiment, the present invention is not limited to those and the configuration of parts can be replaced with any configuration having a similar function, as long as they lie within the scope of the claims.

## Claims

1. A flexible thin sheet-shaped electric wire (40) comprising:
a body part (410) having electrical insulation; and
a conductor part (420) that is arranged in the body part (410), wherein
the conductor part (420) includes a conductor body (421), and a fuse part (422) that is formed in a part of the conductor body (421) and of which a cross-sectional area is smaller than a cross-sectional area of the conductor body (421),
the body part (410) includes a conductor region (411) in which the conductor body (421) is arranged and a fuse region (412) in which the fuse part (422) is arranged, and
the fuse part (422) includes an enclosing part (4223) that is arranged to enclose an entire circumference of at least a part of the fuse region (412).

2. The flexible thin sheet-shaped electric wire (40) according to claim 1, wherein
the enclosing part (4223) has a spiral shape.

3. A flexible thin sheet-shaped electric wire (40) comprising:
a body part (410) having electrical insulation; and
a conductor part (420) that is arranged in the body part (410), wherein
the conductor part (420) includes a conductor body (421) and a fuse part (422) that is formed in a part of the conductor body (421) and of which a cross-sectional area is smaller than a cross-sectional area of the conductor body (421),
the body part (410) includes a conductor region (411) in which the conductor body (421) is arranged and a fuse region (412) in which the fuse part (422) is arranged, and
the fuse part (422) includes a concentrated part (4221) that is arranged in a part of the fuse region (412) such that a density per unit area of the part of the fuse region (412) is higher than a density per unit area of another region.

4. The flexible thin sheet-shaped electric wire (40) according to claim 3, wherein
the concentrated part (4221) has a spiral shape.

5. A bus-bar module (10) comprising:
a case (20) that is assembled on a battery assembly having a plurality of single batteries;
a bus bar (30) that is supported by the case (20) and is electrically connected to the single batteries of the battery assembly; and
a flexible thin sheet-shaped electric wire (40) that is placed in the case (20), wherein
the flexible thin sheet-shaped electric wire (40) includes a body part (410) having electrical insulation, and a conductor part (420) that is arranged in the body part (410),
the conductor part (420) includes a conductor body (421) and a fuse part (422) that is formed in a part of the conductor body (421) and of which a cross-sectional area is smaller than a cross-sectional area of the conductor body (421),
the body part (410) includes a conductor region (411) in which the conductor body (421) is arranged and a fuse region (412) in which the fuse part (422) is arranged, and
the fuse part (422) includes an enclosing part (4223) that is arranged to enclose an entire circumference of at least a part of the fuse region (412).

6. The bus-bar module (10) according to claim 5, wherein
the enclosing part (4223) has a spiral shape.

7. A bus-bar module (10) comprising:
a case (20) that is assembled on a battery assembly having a plurality of single batteries;
a bus bar (30) that is supported by the case (20) and is electrically connected to the single batteries of the battery assembly; and
a flexible thin sheet-shaped electric wire (40) that is placed in the case (20), wherein
the flexible thin sheet-shaped electric wire (40) includes a body part (410) having electrical insulation, and a conductor part (420) that is arranged in the body part (410),
the conductor part (420) includes a conductor body (421) and a fuse part (422) that is formed in a part of the conductor body (421) and of which a cross-sectional area is smaller than a cross-sectional area of the conductor body (421),
the body part (410) includes a conductor region (411) in which the conductor body (421) is arranged and a fuse region (412) in which the fuse part (422) is arranged, and
the fuse part (422) includes a concentrated part (4221) that is arranged in a part of the fuse region (412) such that a density per unit area of the part of the fuse region (412) is higher than a density per unit area of another region.

8. The bus-bar module (10) according to claim 7, wherein
the concentrated part (4221) has a spiral shape.
